# EUROPEAN PATENT APPLICATION

(11) **EP 4 668 505 A1**
(43) Date of publication of application: **24.12.2025**
(21) Application number: 25182410.8
(22) Date of filing: 12.06.2025
(51) Int. Cl.: H01S 5/068, G01S 7/481, H01S 5/42

(54) **OPTICAL COMPONENT WITH CONDUCTIVE TRACE, ASSOCIATED OPTICAL MODULE, AND ASSOCIATED METHOD**

(30) Priority: 18.06.2024 US 202418746712
(71) Applicant: STMicroelectronics International N.V., 1228 Plan-les-Ouates, Geneva (CH)
(72) Inventor: CROCHERIE, Axel, EDINBURGH, EH7 4JB (GB); JOHNSON, Brandon Scott, EDINBURGH, EH6 5TE (GB); WILLIAMS, Fraser, EDINBURGH, EH11 2BY (GB); MAO, Yandong, SHANGHAI, 200240 (GB)
(74) Representative: Casalonga

(57) **Abstract**

In accordance with various embodiments of the present disclosure, an optical component is provided. In some embodiments, the optical component comprises a first active region and an electrically conductive trace comprising at least a first leg and a second leg both on a surface of or embedded in the first active region. The first and second legs each comprise at least substantially straight first, second, and third segments. The second segment of the first leg is positioned at an angle relative to the first and third segments of the first leg. The second segment of the second leg is positioned at an angle relative to the first and third segments of the second leg. The first segments of the first and second legs are substantially parallel. The second segments of the first and second legs are substantially parallel. The third segments of the first and second legs are substantially parallel.

## Description

### FIELD OF THE INVENTION

Example embodiments of the present disclosure relate generally to optical modules and, more particularly, to conductive traces for optical components of optical modules.

### BACKGROUND

Optical modules, such as time-of-flight (ToF) sensors which have a range imaging camera for measuring distances between the camera and a subject based on the round-trip time of an artificial light signal, often use a laser, such as may be provided by a vertical-cavity surface-emitting laser (VCSEL), or other similar light source to emit the light signal. Such optical modules are often used in mobile devices, such as smartphones, to provide features such as camera autofocus and facial recognition.

The light emitted by the light source (e.g., VCSEL) passes through an active region before exiting the optical module. The active region is the area of the optical component that will diffuse/diffract the light from the light source. Such an active region may be, for example, a lens or a flat optics metasurface. Because laser light is potentially harmful to someone nearby, such an active region often diffuses the light to reduce the potential for harm.

However, damage to the active region may reduce its ability to diffuse the light or otherwise allow a dangerous amount and/or concentration of light to be emitted from the optical module. One approach that has been used to detect any such damage to an active region is to place an electrically conductive trace around an edge of and/or on a surface of the active region and to monitor an electrical characteristic (e.g., resistance) of the conductive trace. Damage to the active region that also impinges on the conductive trace will typically cause a change in the electrical characteristic that can be detected, and the output of the light source can be reduced or stopped to avoid harm.

Applicant has identified many technical challenges and difficulties associated with conductive traces of optical modules. Through applied effort, ingenuity, and innovation, Applicant has solved problems related to such conductive traces of optical modules by developing solutions embodied in the present disclosure, which are described in detail below.

### BRIEF SUMMARY

Various embodiments described herein related to optical components with a conductive trace for detecting damage, optical modules having such optical components, methods for detecting damage in optical components of optical modules, and method for evaluating placement of a conductive trace in optical components of optical modules.

**In** accordance with various embodiments of the present disclosure, an optical component is provided. In some embodiments, the optical component comprises a first active region and an electrically conductive trace comprising at least a first leg and a second leg both on a surface of or embedded in the first active region. The first leg comprises at least substantially straight first, second, and third segments. The second leg comprises at least first, second, and third substantially straight segments. The second segment of the first leg is positioned at an angle relative to the first segment of the first leg and to the third segment of the first leg. The second segment of the second leg is positioned at an angle relative to the first segment of the second leg and to the third segment of the second leg. The first segment of the first leg is substantially parallel to the first segment of the second leg. The second segment of the first leg is substantially parallel to the second segment of the second leg. The third segment of the first leg is substantially parallel to the third segment of the second leg.

In some embodiments, the angle at which the second segment of the first leg is positioned relative to the first segment of the first leg and to the third segment of the first leg is substantially equal to ninety degrees, and the angle at which the second segment of the second leg is positioned relative to the first segment of the second leg and to the third segment of the second leg is substantially equal to ninety degrees.

In some embodiments, the first active region comprises a lens or a flat optics metasurface.

In some embodiments, the optical component further comprises a second active region and the electrically conductive trace further comprises a third leg and a fourth leg both on a surface of or embedded in the second active region. The third leg comprises at least first, second, and third substantially straight segments. The fourth leg comprises at least first, second, and third substantially straight segments. The second segment of the third leg is positioned at an angle relative to the first segment of the third leg and to the third segment of the third leg. The second segment of the fourth leg is positioned at an angle relative to the first segment of the fourth leg and to the third segment of the fourth leg. The first segment of the third leg is substantially parallel to the first segment of the fourth leg. The second segment of the third leg is substantially parallel to the second segment of the fourth leg. The third segment of the third leg is substantially parallel to the third segment of the fourth leg.

In some embodiments, the angle at which the second segment of the third leg is positioned relative to the first segment of the third leg and to the third segment of the third leg is substantially equal to ninety degrees, and the angle at which the second segment of the fourth leg is positioned relative to the first segment of the fourth leg and to the third segment of the fourth leg is substantially equal to ninety degrees.

In some embodiments, the electrically conductive trace further comprises a fifth leg on the surface of or embedded in the first active region and a sixth leg on the surface of or embedded in the second active region. The fifth leg comprises at least first, second, and third substantially straight segments. The sixth leg comprises at least first, second, and third substantially straight segments. The second segment of the fifth leg is positioned at an angle relative to the first segment of the fifth leg and to the third segment of the fifth leg. The second segment of the sixth leg is positioned at an angle relative to the first segment of the sixth leg and to the third segment of the sixth leg. The first segment of the fifth leg is substantially parallel to the first segment of the sixth leg. The second segment of the fifth leg is substantially parallel to the second segment of the sixth leg. The third segment of the fifth leg is substantially parallel to the third segment of the sixth leg.

In some embodiments, a position and a spacing of the electrically conductive trace on the surface of or embedded in the first active region is selected such that one or more predetermined shapes having a size corresponding to a predetermined maximum allowable amount of damage that may be incurred by the first active region superimposed anywhere on the first active region would cover at least a portion of the electrically conductive trace.

In some embodiments, the one or more predetermined shapes comprise a square, a rectangle, and a circle.

In some embodiments, the position and the spacing of the electrically conductive trace is selected such that a substantially linear line having a size corresponding to the predetermined maximum allowable amount of damage that may be incurred by the first active region superimposed anywhere on the first active region would intersect the electrically conductive trace.

In some embodiments, a length and/or a width of the electrically conductive trace that is on the surface of or embedded in the first active region is selected such that an amount of transmission loss caused by blockage of light through the first active region by the electrically conductive trace is less than a predetermined maximum allowable transmission loss.

In accordance with various embodiments of the present disclosure, an optical module is provided. In some embodiments, the optical module comprises a housing, a light source disposed in the housing and operable to produce light, a first active region disposed over the light source so as to intersect a path of the light produced by the light source, and an electrically conductive trace comprising at least a first leg and a second leg both on a surface of or embedded in the first active region. The first leg comprises at least substantially straight first, second, and third segments. The second leg comprises at least first, second, and third substantially straight segments. The second segment of the first leg is positioned at an angle relative to the first segment of the first leg and to the third segment of the first leg. The second segment of the second leg is positioned at an angle relative to the first segment of the second leg and to the third segment of the second leg. The first segment of the first leg is substantially parallel to the first segment of the second leg. The second segment of the first leg is substantially parallel to the second segment of the second leg. The third segment of the first leg is substantially parallel to the third segment of the second leg.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a perspective view of an example optical module having an example optical component, in accordance with some embodiments of the present disclosure;
FIG. 2 is a top view of the example optical component from the example optical module of FIG. 1;
FIG. 3 is a top view of the example optical component of the example optical module of FIG. 1 illustrating a method of evaluating placement of a conductive trace in optical components of optical modules; and
FIG. 4 is a top view of an example optical component of an example optical module, in accordance with some alternative embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various embodiments of the present disclosure overcome the above technical challenges and difficulties and provide various technical improvements and advantages based on, for example, but not limited to, providing an optical component having at least one active region (e.g., lens or flat optics metasurface) and an electrically conductive trace on a surface of or embedded in the active region. In various embodiments, the conductive trace has two or more parallel zigzag legs. That is, in various embodiments, each leg comprises at least three substantially straight segments that are angled back and forth in a zigzag manner, with each segment of one leg substantially parallel to a corresponding segment of the other leg. The regularity and the parallel spacing of the zigzag legs provide a placement of the conductive trace that provides good protective coverage for detecting damage to the active region while keeping the transmission loss due to blockage of the light by the conductive trace low. In various embodiments, trace resistance will also determine the amount of coverage (i.e., by determining trace length).

In various embodiments, an optical component has two active regions (e.g., lens or flat optics metasurface) and two or more parallel zigzag legs of the electrically conductive trace are positioned on the surface of or embedded in each of the active regions.

In some embodiments, the angle between each segment of each leg is substantially equal to ninety degrees, which further contributes to the good protective coverage and low transmission loss.

In various embodiments, the positioning and spacing of the legs of the conductive traces are selected and/or evaluated based on a predetermined maximum allowable area of damage. In various embodiments, such a predetermined maximum allowable area of damage refers to the most damage (by area) that can occur to an active region before a potentially damaging amount of light would be emitted through the active region. In various embodiments, such a predetermined maximum allowable area of damage may vary based on many different factors, including but not limited to the light source (e.g., type, power), the active region (type, purpose), and/or the optical module (e.g., type, purpose).

In various embodiments, one or more predetermined shapes that each have a size (i.e., area) corresponding to the predetermined maximum allowable amount of damage are used to select and/or evaluate the positioning and spacing of the legs of the conductive trace. In some embodiments, the predetermined shapes are a square, a rectangle, and a circle. In various embodiments, it is determined if the one or more predetermined shapes can be superimposed in any position on the active region and cover at least a portion of the conductive trace regardless of the position of the superimposed shape(s). In various embodiments, if there are any positions in which the superimposed shape(s) would not cover at least a portion of the conductive trace, then the positioning and/or spacing of the conductive trace is not acceptable. Conversely, if the superimposed shape(s) would cover at least a portion of the conductive trace in all possible positions, then the positioning and/or spacing of the conductive trace is acceptable. In various embodiments, such a determination is made using all three such predetermined shapes (i.e., square, rectangle, and circle). In various alternative embodiments, such a determination is made using any one or more of such predetermined shapes.

In various embodiments, an elongated line or an especially elongated rectangle (i.e., length much greater than width) is used as one of the predetermined shapes. Such a line or an especially elongated rectangle is representative of a scratch on the surface of the active region.

Selecting and/or evaluating the positioning and spacing of the conductive trace based on a predetermined maximum allowable amount of damage helps ensure that the conductive trace will detect a dangerous amount of damage to the active region. Using such predetermined shapes to select and/or evaluate the positioning and spacing of the conductive trace based on a predetermined maximum allowable amount of damage provides a quick and efficient method for such an analysis.

In various embodiments, the amount of transmission loss caused by the conductive trace is compared to a predetermined maximum allowable transmission loss to ensure that the conductive trace does not cause an unacceptable amount of transmission loss. By combining the analysis of the positioning and spacing of the conductive trace based on a predetermined maximum allowable amount of damage and the analysis of the amount of transmission loss caused by the conductive trace as compared to a predetermined maximum allowable transmission loss, various embodiments of the present disclosure enable selection and/or confirmation of the positioning and spacing of the conductive trace that provides a desired amount of damage detection without an undesirable amount of transmission loss.

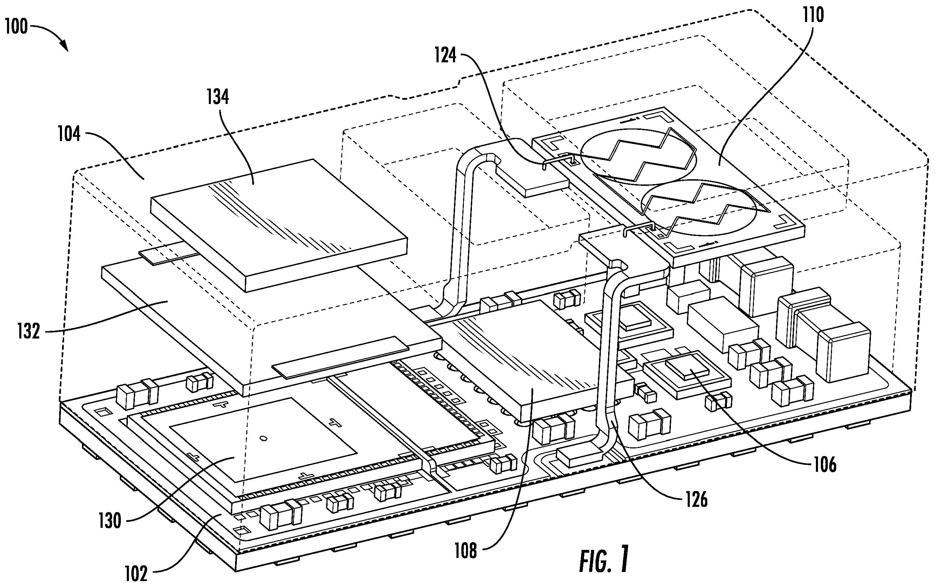

FIG. 1 is a perspective view of an example optical module, in accordance with some embodiments of the present disclosure. Such an optical module may be installed in, for example, a mobile device such as a mobile phone. As seen in FIG. 1, an example optical module 100 comprises a substrate 102 and a housing 104 (illustrated as transparent for visibility of the internal components). In the illustrated embodiment, the optical module 100 has a transmit side (right) and a receive side (left).

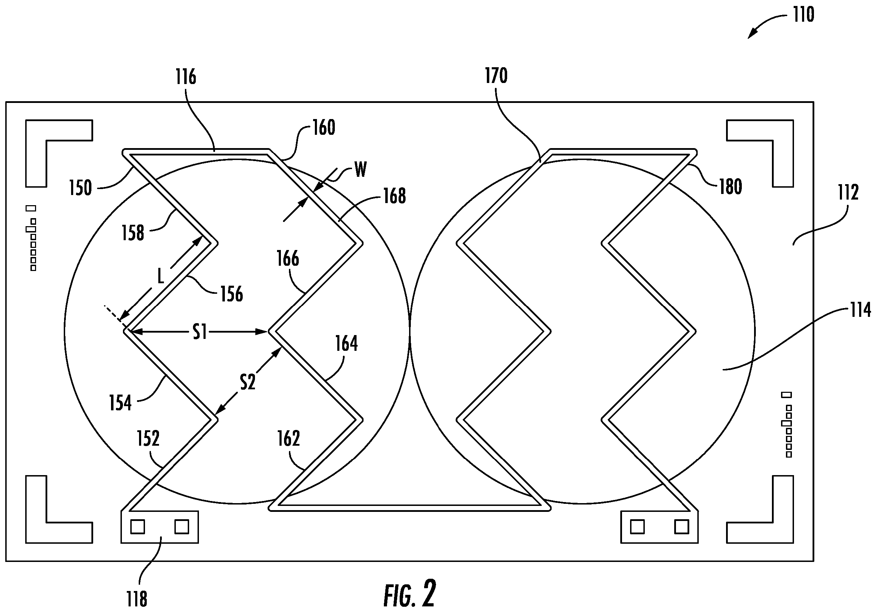

In various embodiments, a variety of components (electrical, electronic, and mechanical) are contained within an internal chamber defined by the substrate 102 and the housing 104. In various embodiments, these components include TX components for emitting light and RX components for receiving reflected light. In various embodiments, the TX components include one or more light sources 106, such as one or more VCSELs (two are shown), and an optical component 110 (described further below in relation to FIG. 2) that includes one or more active regions 114 (two are shown) and an electrically conductive trace 116 (shown positioned on a mounting substrate 112). As illustrated, the one or more active regions 114 are positioned above and in line with the one or more light sources 106 to focus and/or diffuse the light emitted by the one or more light sources 106. In various embodiments, the one or more active regions comprise one or more lenses, flat optics metasurfaces, diffusers, etc.

As seen in FIG. 1, the conductive trace 116 of the optical component 110 is electrically connected via a bond wire 124 to a leadframe 126, which in turn is electrically connected to a component on the substrate 102 that monitors an electrical characteristic (e.g., resistance) of the conductive trace 116. In various embodiments, the component that monitors an electrical characteristic of the conductive trace 116 is a VCSEL driver 108.

Light from the one or more light sources 106 reflects off objects and returns to the receive side in which the reflected light passes through an RX filter 134 and an RX lens 132 and is received by an RX sensor 130.

FIG. 2 is a top view of the optical component 110 removed from the example optical module of FIG. 1, in accordance with some embodiments of the present disclosure. As seen in FIG. 2, the optical component 110 comprises two active regions 114 on a substrate 112. A conductive trace 116 is positioned on the surfaces of both of the active regions 114 (alternatively, the conductive trace could be embedded in the active regions). Each end of the conductive trace 116 is electrically connected to a bond pad 118, which is in turn electrically connected to the bond wires 124 described above.

As illustrated in FIG. 2, the conductive trace 116 comprises a first leg 150 and a second leg 160 that are at least partly on a first (left) one of the active regions and a third leg 170 and a fourth leg 180 that are at least partly on a second (right) one of the active regions. In the illustrated embodiments, the first leg 150 and the second leg 160 are a mirror image of the third leg 170 and the fourth leg 180. As such, only the first leg 150 and the second leg 160 are described in detail herein. In some embodiments, the legs of the conductive trace on one of the active regions may be identical to the legs of the conductive trace on another of the active regions. In some embodiments, the legs of the conductive trace on one of the active regions may differ from the legs of the conductive trace on another of the active regions. As described further below, in some embodiments the conductive trace may have three or more legs on or in each of the active regions.

As illustrated in FIG. 2, the first leg 150 and the second leg 160 of the conductive trace are parallel zigzag legs. That is, in various embodiments, each leg comprises at least three substantially straight segments that are angled back and forth in a zigzag manner. In the illustrated embodiment, each leg comprises four substantially straight segments that are angled back and forth in a zigzag manner. In the illustrated embodiment, the first leg 150 comprises a substantially straight first segment 152, a substantially straight second segment 154, a substantially straight third segment 156, and a substantially straight fourth segment 158, and the second leg 160 comprises a substantially straight first segment 162, a substantially straight second segment 164, a substantially straight third segment 166, and a substantially straight fourth segment 168.

In various embodiments, the legs on each active region are parallel in that each segment of one leg on an active region is parallel to a corresponding segment of the other leg(s) on that active region. As illustrated in FIG. 2, the first segment 152 of the first leg 150 and the first segment 162 of the second leg 160 are parallel, the second segment 154 of the first leg 150 and the second segment 164 of the second leg 160 are parallel, the third segment 156 of the first leg 150 and the third segment 166 of the second leg 160 are parallel, and the fourth segment 158 of the first leg 150 and the fourth segment 168 of the second leg 160 are parallel. As illustrated, the third leg 170 and the fourth leg 180 are similarly parallel to each other.

The regularity and the parallel spacing of the zigzag legs provide a placement of the conductive trace that provides good protective coverage for detecting damage to the active region while keeping the transmission loss due to blockage of the light by the conductive trace low.

As illustrated in FIG. 2, the length of each segment may be termed "L," the width of each segment may be termed "W," the spacing or distance between the angled connection of two adjoining segments on one leg and two adjoining segments on the other leg may be termed "S1," and the spacing or distance between two corresponding parallel segments of two legs (as measured perpendicularly to the segments) may be termed "S2."

In the illustrated embodiment, each segment of the conductive trace is at a ninety-degree angle to the respective adjoining segment(s), although any suitable angle may be used in agreement with the design rules allowed by the technology used for the process. In various embodiments, the point of connection between each segment may be a sharp angle or may be curved (if curved, the curve may have any suitable radius). In various embodiments, the number of legs, the number of segments of each leg, the length of each segment, and the position of each segment may all vary as needed to provide the desired safety coverage and emission loss (described further below).

In various embodiments, the position and spacing of the electrically conductive trace on the surface of or embedded in the active region(s) are selected based on a predetermined maximum allowable amount of damage that may be incurred by the active region (or by each active region, if there is more than one). As described above, such a predetermined maximum allowable area of damage refers to the most damage (by area) that can occur to an active region before a potentially damaging amount of light would be emitted through the active region. In various embodiments, such a predetermined maximum allowable area of damage may be determined using any suitable process. In one such example process, the maximum allowable power to be below the injury threshold for eye and skin safety in a case of a defect on the active region(s) is determined. In parallel, either by simulation or by characterization, the law of the power passing through the defect in function of the defect size is determined. This enables calculation of the maximum defect size to be below the injury threshold, and the design of the conductive trace is done according to this result.

In various embodiments, one or more predetermined shapes that each have a size (i.e., area) corresponding to the predetermined maximum allowable amount of damage are used to select and/or evaluate the positioning and spacing of the legs of the conductive trace. In some embodiments, the predetermined shapes are a square, a rectangle, and a circle.

In various embodiments, it is determined if the one or more predetermined shapes can be superimposed in any position on the active region and cover at least a portion of the conductive trace in all positions. In various embodiments, if there are any positions in which the superimposed shape would not cover at least a portion of the conductive trace, then the positioning and/or spacing of the conductive trace is not acceptable. Conversely, if the superimposed shape would cover at least a portion of the conductive trace in all possible positions, then the positioning and/or spacing of the conductive trace is acceptable. In various embodiments, such a determination is made using all three such predetermined shapes (i.e., square, rectangle, and circle).

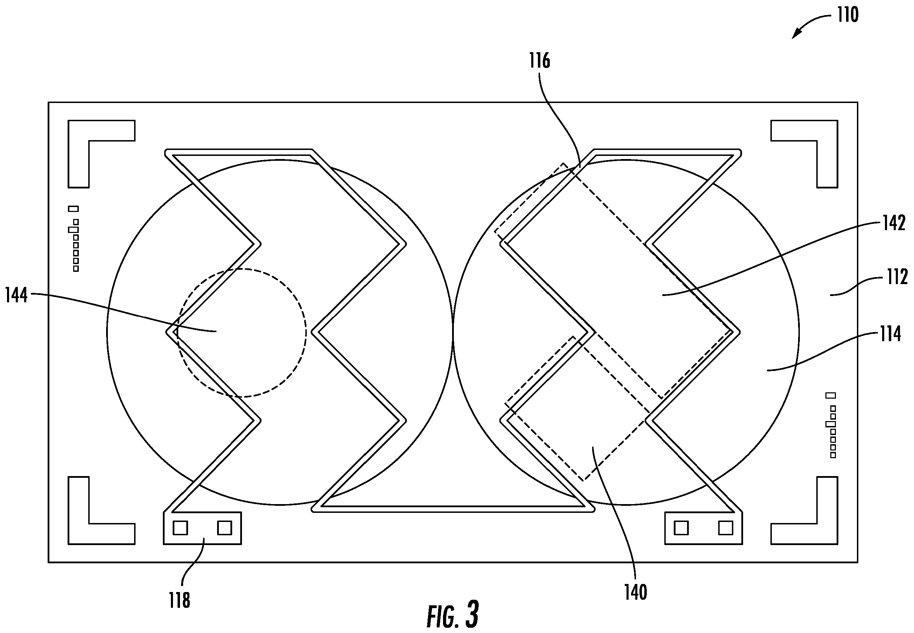

Referring now to FIG. 3, the optical component 110 of FIG. 2 is shown with a square 140, a rectangle 142, and circle 144 superimposed thereupon. It should be appreciated that the shapes in FIG. 3 are for illustration purposes only, are not to scale, and do not all represent the same maximum allowable amount of damage. In real-world implementations of embodiments of the invention, the shapes used would be to scale and would each represent the same maximum allowable amount of damage. In various embodiments, different and/or additional shapes could be used. In various embodiments, the example shapes of FIG. 3 illustrate spacing of the conductive trace 116 that would be acceptable as all three shapes are in positions in which the shapes cover or cross at least some part of the conductive trace 116. As such in the example of FIG. 3, damage greater than the maximum allowable amount would not likely occur without affecting the conductive trace and therefore without being detectable.

In various embodiments, the determination whether the one or more predetermined shapes can be superimposed in any position on the active region and cover at least a portion of the conductive trace is based on a mathematical comparison of one or more dimensions of each shape to one or more dimensions of the conductive traces. In various embodiments, this mathematical comparison involves converting the predetermined maximum amount of allowable damage (in surface area) into a corresponding circle with a specific diameter, a corresponding square with a specific width/length, and a corresponding rectangle with a specific width and length, all of which are each representative of the predetermined maximum amount of allowable damage. For example, in various embodiments, the following conversions are made:
(1) the predetermined maximum amount of allowable damage (in surface area "A") is converted into a corresponding circle having a diameter D, using the equation D = 2*sqrt(A/pi);
(2) the predetermined maximum amount of allowable damage (in surface area "A") is converted into a corresponding square having a width X and length X, using the equation X = sqrt(A); and
(3) the predetermined maximum amount of allowable damage (in surface area "A") is converted into a corresponding rectangle having a width X and a length Y (in which the length is twice its width, i.e., Y = 2X), using the equations X = sqrt(A/2) and Y = sqrt(2A).

In various embodiments, the dimensions of the corresponding circle, square, and rectangle are then compared to the conductive trace placement, specifically to the length "L of each segment, the width "W" of each segment, the spacing or distance "S1" between the angled connection of two adjoining segments on one leg and two adjoining segments on the other leg, and/or the spacing or distance "S2" between corresponding two corresponding parallel segments of two legs.. For example, in various embodiments, one or more of the following comparisons are made:
(1) for a circle having a diameter D, it is determined if D > L-W, if D > S1, and/or if D > S2;
(2) for a square having a width X and length X, it is determined if X > L-W and/or if X > S2; and
(3) for a rectangle having a width X and a length Y, it is determined if X > L-W and Y > 2(L-W) and/or if X > S2 and Y > S2.

In such an example embodiment, if one or more of the comparisons for the circle, one or more of the comparisons for the square, and one or more of the comparisons for the rectangle are met, then the spacing of the conductive trace is such that any damage over the maximum allowable amount of damage is likely to damage the conductive trace and therefore be detected. As such, in various embodiments, the spacing of the conductive trace is selected such that one or more of the comparisons for the circle, one or more of the comparisons for the square, and one or more of the comparisons for the rectangle are met.

In various embodiments, it can also be determined if the position and spacing of the conductive trace is sufficient to detect a damaging scratch. Conceptually, a scratch may be considered an elongated line or an elongated rectangle in which the length is much greater than the width. In various embodiments, a scratch long enough to cause more than the allowable amount of damage would be detected if the zigzag legs are close enough to each other such that S1 < ((L + 2W) * sqrt2 / 2).

It should be appreciated that using one or more such predetermined shapes as described herein provides, in various embodiments, an acceptable estimated confirmation that the position and spacing of the conductive trace is sufficient to detect damage to the active region exceeding the maximum allowable amount of damage. Because actual damage may occur in different, irregular shapes, using one or more such predetermined shapes as described herein may not provide complete certainty that the position and spacing of the conductive trace is sufficient to detect damage to the active region exceeding the maximum allowable amount of damage.

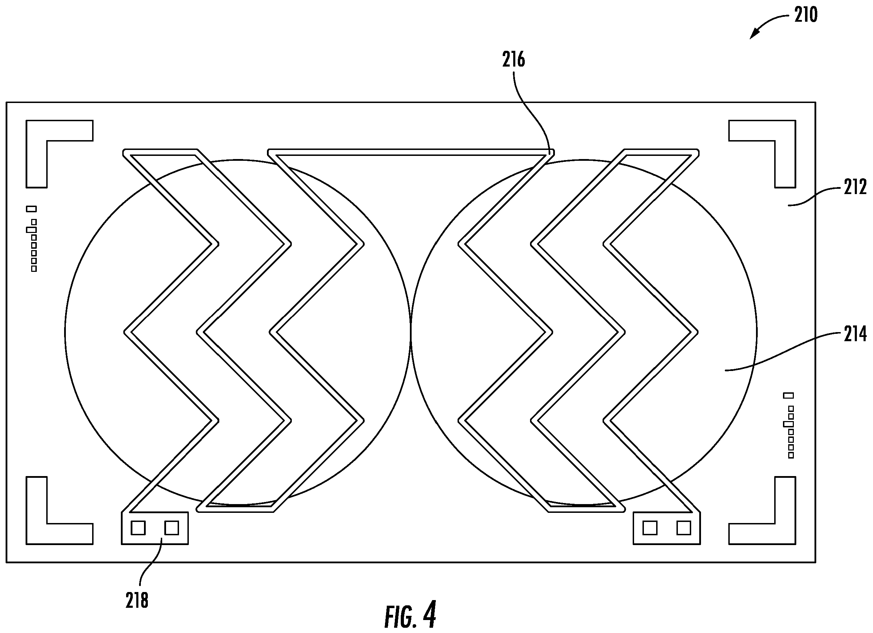

FIG. 4 is a top view of an optical component 210 of an example optical module, in accordance with some alternative embodiments of the present disclosure. As seen in FIG. 4, the optical component 210 comprises two active regions 214 on a substrate 212. A conductive trace 216 is positioned on the surfaces of both of the active regions 214 (alternatively, the conductive trace could be embedded in the active regions). Each end of the conductive trace 216 is electrically connected to a bond pad 218, which is in turn electrically connected to bond wires as described above. As illustrated in FIG. 4, the conductive trace 216 comprises three parallel zigzag legs that are at least partly on a first (left) one of the active regions and three parallel zigzag legs that are at least partly on a second (right) one of the active regions. In various embodiments, a conductive trace may have any suitable number of parallel zigzag legs.

### Conclusion

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components may be used in conjunction with the system. Therefore, it is to be understood that the disclosures are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the disclosure(s) set out in any claims that may issue from this disclosure.

While this detailed description has set forth some embodiments of the present disclosure, the appended claims cover other embodiments of the present disclosure which differ from the described embodiments according to various modifications and improvements. For example, the appended claims can cover any form of optical module having a conductive trace for detecting damage to an active region of an optical component. Within the appended claims, unless the specific term "means for" or "step for" is used within a given claim, it is not intended that the claim be interpreted under 35 U.S.C. 112, paragraph 6.

## Claims

1. An optical component (110) comprising:
a first active region (114); and
an electrically conductive trace (116) comprising at least a first leg (150) and a second leg (160) both on a surface of or embedded in the first active region, the first leg comprising at least substantially straight first, second, and third segments (152, 154, 156), the second leg comprising at least first, second, and third substantially straight segments (162, 164, 166);
wherein the second segment of the first leg is positioned at an angle relative to the first segment of the first leg and to the third segment of the first leg;
wherein the second segment of the second leg is positioned at an angle relative to the first segment of the second leg and to the third segment of the second leg;
wherein the first segment of the first leg is substantially parallel to the first segment of the second leg;
wherein the second segment of the first leg is substantially parallel to the second segment of the second leg; and
wherein the third segment of the first leg is substantially parallel to the third segment of the second leg.

2. The optical component of claim 1, wherein the angle at which the second segment of the first leg is positioned relative to the first segment of the first leg and to the third segment of the first leg is substantially equal to ninety degrees; and
the angle at which the second segment of the second leg is positioned relative to the first segment of the second leg and to the third segment of the second leg is substantially equal to ninety degrees.

3. The optical component of claim 1 or claim 2, wherein the first active region comprises a lens or a flat optics metasurface.

4. The optical component of any one of claims 1 to 3, wherein a position and a spacing of the electrically conductive trace on the surface of or embedded in the first active region is selected such that one or more predetermined shapes having a size corresponding to a predetermined maximum allowable amount of damage that may be incurred by the first active region superimposed anywhere on the first active region would cover at least a portion of the electrically conductive trace.

5. The optical component of claim 4, wherein the one or more predetermined shapes comprise a square, a rectangle, and a circle.

6. The optical component of claim 4 or claim 5, wherein the position and the spacing of the electrically conductive trace is selected such that a substantially linear line having a size corresponding to the predetermined maximum allowable amount of damage that may be incurred by the first active region superimposed anywhere on the first active region would intersect the electrically conductive trace.

7. The optical component of any one of claims 1 to 6, wherein a length and/or a width of the electrically conductive trace that is on the surface of or embedded in the first active region is selected such that an amount of transmission loss caused by blockage of light through the first active region by the electrically conductive trace is less than a predetermined maximum allowable transmission loss.

8. The optical component of any one of claims 1 to 7, further comprising a second active region (114);
wherein the electrically conductive trace further comprises a third leg (170) and a fourth leg (180) both on a surface of or embedded in the second active region, the third leg comprising at least first, second, and third substantially straight segments, the fourth leg comprising at least first, second, and third substantially straight segments;
wherein the second segment of the third leg is positioned at an angle relative to the first segment of the third leg and to the third segment of the third leg;
wherein the second segment of the fourth leg is positioned at an angle relative to the first segment of the fourth leg and to the third segment of the fourth leg;
wherein the first segment of the third leg is substantially parallel to the first segment of the fourth leg;
wherein the second segment of the third leg is substantially parallel to the second segment of the fourth leg; and
wherein the third segment of the third leg is substantially parallel to the third segment of the fourth leg.

9. The optical component of claim 8, wherein the angle at which the second segment of the third leg is positioned relative to the first segment of the third leg and to the third segment of the third leg is substantially equal to ninety degrees; and
the angle at which the second segment of the fourth leg is positioned relative to the first segment of the fourth leg and to the third segment of the fourth leg is substantially equal to ninety degrees.

10. The optical component of claim 8 or claim 9, wherein the electrically conductive trace further comprises a fifth leg on the surface of or embedded in the first active region and a sixth leg on the surface of or embedded in the second active region, the fifth leg comprising at least first, second, and third substantially straight segments, the sixth leg comprising at least first, second, and third substantially straight segments;
wherein the second segment of the fifth leg is positioned at an angle relative to the first segment of the fifth leg and to the third segment of the fifth leg;
wherein the second segment of the sixth leg is positioned at an angle relative to the first segment of the sixth leg and to the third segment of the sixth leg;
wherein the first segment of the fifth leg is substantially parallel to the first segment of the sixth leg;
wherein the second segment of the fifth leg is substantially parallel to the second segment of the sixth leg; and
wherein the third segment of the fifth leg is substantially parallel to the third segment of the sixth leg.

11. An optical module comprising:
a housing;
a light source disposed in the housing and operable to produce light; and
an optical component according to any one of claims 1 to 7,
wherein the first active region is disposed over the light source so as to intersect a path of the light produced by the light source.

12. The optical module of claim 11, the optical component being further characterized according to any one of claims 8 to 10, the optical module further comprising:
a second light source disposed in the housing and operable to produce light;
wherein the second active region is disposed over the second light source so as to intersect a path of the light produced by the second light source

13. The optical module of claim 11 or claim 12, wherein the optical module comprises a time-of-flight sensor or an image sensor.
